# EUROPÄISCHE PATENTSCHRIFT

(11) **EP 2 454 583 B1**
(45) Veröffentlichungstag und Bekanntmachung des Hinweises auf die Patenterteilung: **16.10.2019**
(21) Anmeldenummer: 10717123.3
(22) Anmeldetag: 28.04.2010
(51) Int. Cl.: G01N 21/95, H01L 21/68, H01L 21/687, G01N 21/89, H01L 21/67

(54) **INSPEKTIONSSYSTEM**
INSPECTION SYSTEM
SYSTÈME D'INSPECTION

(30) Priorität: 16.07.2009 DE 102009026187
(43) Veröffentlichungstag der Anmeldung: 23.05.2012
(73) Patentinhaber: Unity Semiconductor GmbH, 01099 Dresden (DE)
(72) Erfinder: SROCKA, Bernd, 13125 Berlin (DE); DÖRING, Marko, 01109 Dresden (DE)
(74) Vertreter: Weisse, Renate
(86) Internationale Anmeldenummer: PCT/EP2010/055741
(87) Internationale Veröffentlichungsnummer: WO 2011/006687

(56) Entgegenhaltungen:
- EP-A2- 1 061 358
- JP-A- 3 057 974
- JP-A- 2008 304 612
- US-A1- 2008 231 301
- US-A1- 2008 290 886

## Beschreibung

### Technisches Gebiet

Die Erfindung betrifft ein Inspektionssystem für flache Objekte, insbesondere Wafer und Dies, enthaltend
(a) ein Handling-System zum Beladen des Inspektionssystems mit Objekten;
(b) eine Sensoranordnung zur Aufnahme von Bildern oder Messwerten der Objektoberfläche oder Teilen der Objektoberfläche; und
(c) eine Antriebsanordnung zur Erzeugung einer Relativbewegung zwischen den Objekten und der Sensoranordnung, bei welcher eine Bewegung von Objekten relativ zu der Sensoranordnung entlang einer ersten Trajektorie erfolgt; und
(d) wenigstens eine weitere Sensoranordnung zur Aufnahme von Bildern oder Messwerten der Objektoberfläche oder Teilen der Objektoberfläche.

Unter Trajektorie wird hier eine Zeitsequenz von Koordinaten verstanden, welche den Bewegungspfad eines Objektes während der Laufzeit darstellt. Dabei kann ein Objekt relativ zu einem feststehenden Sensor bewegt werden. Es kann aber auch eine Sensoranordnung relativ zu einem feststehenden Objekt bewegt werden. Schließlich besteht auch die Möglichkeit sowohl den Sensor, als auch das Objekt zueinander zu bewegen.

In verschiedenen Industriezweigen werden flächige Produkte mit optischen, bildgebenden Verfahren auf Fehler untersucht. In der Halbleiter- und Solarzellenindustrie sind dies unter anderem Wafer. Wafer sind Scheiben aus Halbleiter-, Glas-, Folien- oder Keramikmaterialien. Die Wafer werden in bestimmten Anwendungen typischerweise ganzflächig oder zumindest auf großen Teilflächen geprüft. Diese Prüfung nennt man Makro-Inspektion. Die für die Erkennung der gesuchten Fehler erforderliche laterale Auflösung steigt dabei mit der Weiterentwicklung der allgemeinen Produktionstechnik. Typischerweise werden für neue Technologien Auflösungen in der Makro-Inspektion von 5 µm verlangt. Gleichzeitig sind Geräte mit einem hohen Durchsatz an zu prüfenden Wafern wünschenswert.

Gegenwärtig verfügbare Makro-Inspektionssysteme erbringen entweder den gewünschten Durchsatz oder die gewünschte Auflösung, jedoch nicht beides gleichzeitig. Es besteht daher ein Bedarf an schnelleren und gleichzeitig besser auflösenden Makro-Inspektionssystemen.

Analoge Aufgabenstellungen sind in anderen Industriezweigen zu lösen. In der Flat-Panel-Industrie sind die Displays in der Produktion auf Fehler zu prüfen. Dabei werden zum Teil ganzflächig auf den Displays bildgebende Verfahren zur Fehlersuche benutzt. In der Elektroindustrie werden bei der Prüfung von Leiterplatten Fehler mit optischen Verfahren auf Serien von Prüflingen, insbesondere Leiterplatten, ermittelt.

Gemeinsam ist allen diesen Anwendungen der Bedarf an schneller Prüfung einer hohen Anzahl von in der Regel gleichartigen Prüflingen. Solche Objekte sind Leiterplatten, Wafer, Solarzellen, Displays und dergleichen. Gemeinsam ist den Anwendungen auch der Einsatz von Sensoren zur Erzeugung von großflächigen Abbildungen der Prüflinge. Die Abbildungen können je nach Art des gesuchten Fehlers sowohl mit optisch fotografierenden Systemen als auch mit punktuell arbeitenden Sensoren erzeugt werden. Optisch fotografierende Systeme sind beispielsweise Flächen- oder Zeilenkameras. Punktuell arbeitende Sensoren sind beispielsweise Detektoren zur Messung der Reflektion von optischen Strahlen, Mikrowellen oder Schallwellen. Es können auch magentische Sensoren eingesetzt werden.

### Stand der Technik

US 2006/0119366A1 (Iffland) offenbart ein Inspektionssystem mit einer Ladeeinheit und einem Gerät zur gleichzeitigen Untersuchung der Vorder- und Rückseite eines Objekts.

WO 02/089183A2 (Leica Microsystems Jena GmbH) offenbart eine Halterung für Objekte mit zwei Greifern, welche auf einem Arm montiert sind, der um 180° drehbar ist.

US 2008/0231301 A1 offenbart ein elektrisches Inspektionsgerät, bei welchem ein Prober mit einer Vielzahl von elektrischen Kontakten über einem Wafer positioniert wird und auf seine Funktionalität geprüft wird. Da die elektrischen Kontakte sehr genau positioniert werden müssen, ist ein Ausrichtungssystem mit zwei Kameras vorgesehen. Das Ausrichtungssystem umfasst eine erste Kamera, die auf einer Brücke bewegt wird. Im Randbereich der Untersuchungstische sind zweite Kameras angeordnet, die zusammen mit dem Tisch in einer rechteckigen Fläche bewegt werden. Bei den Kameras handelt es sich nicht um die Sensoranordnungen für die Inspektion an sich, sondern lediglich um Teile des Aussrichtungssystems. Die "Inspektion" erfolgt mit dem Prober.

US 2008/0290886 A1 beschreibt eine Anordnung bei der zwei Inspektionseinheiten für zwei Waferaufnahmen. Die Wafer werden mit einer für beide Inspektionseinheiten gemeinsamen Transfereinheit auf die Waferaufnahmen transportiert. Jeweils zwei Kameras an jeweils einer Brücke werden zur Bildaufnahme mit der Brücke über den zugehörigen Wafer bewegt. Zwischen den Inspektionseinheiten befindet sich eine Trennwand. Es ist nicht möglich, die Kameras in den Bereich beider Inspektionseinheiten zu fahren. Das bedeutet, dass jeweils zwei Kameras, nämlich eine Kamera mit großer Vergrößerung und eine Kamera mit geringerer Vergrößerung an jeder der Brücken angeordnet werden müssen. Es müssen für jede der Waferaufnahmen vollständige Sensoranordnungen mit allen erforderlichen Auflösungen und Vergrößerungen verwendet werden. Das ist teuer.

### Offenbarung der Erfindung

Es ist Aufgabe der Erfindung ein Inspektionssystem zu schaffen, mit welchem die Objekte schneller und mit hoher Auflösung untersucht werden können. Erfindungsgemäß wird die Aufgabe bei einer Anordnung der eingangs genannten Art dadurch gelöst, dass
(e) mit der Antriebsanordnung eine weitere Relativbewegung erzeugbar ist, bei welcher eine Bewegung von anderen Objekten relativ zu jeder der Sensoranordnungen auf wenigstens einer zweiten Trajektorie erzeugbar ist, so dass Bilder oder Messwerte der Objektoberfläche oder von Teilen der Objektoberfläche von wenigstens zwei Objekten gleichzeitig mit den Sensoranordnungen aufnehmbar sind und wobei
(f) jede der Sensoranordnungen in den Bereich aller Trajektorien bewegbar ist.

Mit einer solchen Anordnung können mehrere Objekte gleichzeitig verarbeitet werden, ohne dass zusätzliche, teure Sensoranordnungen eingesetzt werden müssen. Zu den Verarbeitungsschritten gehören insbesondere das Beladen und Justieren der Objekte, das Erzeugen von Bildern und die Auswertung dieser Bilder.

Vorzugsweise sind die Objekte auf zwei geraden parallelen Trajektorien bewegbar. Auch die Sensoranordnungen können auf geraden parallelen Trajektorien bewegbar sein. Dabei können die Trajektorien der Sensoranordnungen windschief mit rechtwinkliger Projektion zu den Trajektorien der Objekte verlaufen. Eine solche Anordnung wird beispielsweise verwirklicht durch eine Anordnung, bei welcher die Trajektorien von raumfesten Führungen gebildet sind, welche jeweils einen darin geführten, verschiebbaren Hub-Drehtisch zur Aufnahme und Ausrichtung der Objekte aufweisen. Die Sensoranordnungen können jeweils auf einem sich oberhalb der Trajektorien der Objekte befindlichen Portalbalken verschiebbar geführt sein. Mit anderen Worten: die Objekte werden parallel in einer X-Richtung bewegt und die Sensoranordnungen oberhalb davon parallel in einer Y-Richtung.

Während eines der Objekte von einem der Sensoren aufgenommen wird, kann bereits gleichzeitig ein weiteres Objekt geladen oder mit dem anderen Sensor aufgenommen werden. Die Sensoren werden dadurch besonders gut ausgelastet und der Durchsatz an Objekten erhöht.

Vorzugsweise umfassen die Sensoranordnungen wenigstens einen Mikroskopkopf. Der Mikroskopkopf hat vorzugsweise mehrere Vergrößerungsstufen. Die Sensoranordnungen können weiterhin wenigstens einen Scankopf umfassen. In einer besonders bevorzugten Ausgestaltung der Erfindung sind ein Mikroskopkopf und ein Scankopf vorgesehen.

Unter einem Mikroskopkopf (im Folgenden auch Mikroskopkopf genannt) wird hier ein Inspektionskopf mit einem Mikroskop verstanden. Das Mikroskop umfasst insbesondere ein Kamerasystem zur Aufnahme von mikroskopischen Detailbildern, sowie zur Erledigung von Vorbereitungsarbeiten. Solche Vorbereitungsarbeiten sind insbesondere die Waferausrichtung, die Bestimmung der Fokusebene, die Bestimmung der Waferdurchbiegung bei der Rückseiteninspektion und die Waferdurchbiegung bei Wafern, welche nur am Rand aufliegen. Ein solches Kamerasystem umfasst vorzugsweise eine Farbkamera.

Unter einem Scankopf wird hier ein Inspektionskopf mit einem Makroobjektiv verstanden. Weiterhin ist ein Kamerasystem vorgesehen, mit welchem der gesamte Wafer oder größere Teilbereiche des Wafers abgetastet werden können. Ein solches Kamerasystem kann mit einer Flächenkamera oder mit einer Zeilenkamera verwirklicht werden. Das Kamerasystem umfasst vorzugsweise ein Farbkamera.

Insbesondere bei der Waferinspektion wird mit einer Kombination aus Mikroskopkopf und Scankopf eine vollständig automatische Inspektion des gesamten Wafers realisiert. Die Inspektion kann sowohl für die eigenständige Bewertung des Wafers genutzt werden, als auch als Basis für ein nachfolgendes Review mittels der zweiten Sensoranordnung in Form eines Mikroskops. Bei Einsatz geeigneter Sensorkombinationen kann eine Auflösung im unteren µm-Bereich erreicht werden. Bei der Kombination mit einer automatischen Mikroskop-Inspektion entsteht keine Detektionslücke.

In einer alternativen Ausgestaltung der Erfindung werden zwei oder mehr Scanköpfe verwendet. In einer weiteren Ausgestaltung der Erfindung werden zwei oder mehr Mikroskopköpfe verwendet. Derartige Ausgestaltungen können je nach Verwendung zu einer Erhöhung des Durchsatzes führen. Statt einer Farbkamera kann auch eine Schwarz-Weiß-Kamera als Sensoranordnung eingesetzt werden.

In einer weiteren alternativen Ausgestaltung der Erfindung werden insbesondere auf der ersten Sensorkopftrajektorie ein Mikroskopkopf und auf der zweiten Sensorkopftrajektorie zwei Scanköpfe verwendet, welche sich jedoch eine Führungseinheit teilen. Solche Führungseinheiten, bestehend aus einer Führung, passiven Antriebs-Komponenten und zwei voneinander unabhängig steuerbaren aktiv angetriebenen beweglichen Wagen sind kommerziell beispielsweise von Aerotech Inc erhältlich.

In dieser Ausgestaltung wird der Mikroskopkopf ausschließlich für die vorbereitenden Schritte, wie etwa Ausrichtung und Höhenbestimmung eingesetzt, während beide Scanköpfe zum scannen der Objekte eingesetzt werden. Mit einer solchen Anordnung lässt sich ein besonders hoher Durchsatz bei Verzicht auf die Möglichkeit der Aufnahme von Detailbildern erzielen.

Vorzugsweise ist wenigstens eine der Sensoranordnungen ein Flächensensor mit einer zweidimensionalen Anordnung von Detektorelementen.

Ein erfindungsgemäßes Verfahren zur Durchführung einer Inspektion einer Vielzahl von flachen Objekten, insbesondere Wafern und Dies, mit einem solchen Inspektionssystem umfasst die Schritte
(a) Beladen des Inspektionssystems mit einem Objekt zur Bewegung auf einer ersten Trajektorie;
(b) Aufnehmen wenigstens eines Bildes oder eines Messwertes des Objekts oder eines Teils des Objekts mit einer ersten Sensoranordnung; und
(c) Aufnehmen eines weiteren Bildes oder eines weiteren Messwertes des Objekts oder eines Teils des Objekts mit einer zweiten Sensoranordnung;

Das Verfahren ist dadurch gekennzeichnet, dass
(d) während der Durchführung eines der Schritte (a) bis (c) ein anderer der Schritte (a) bis (c) für ein weiteres Objekt durchgeführt wird, welches sich auf einer zweiten Trajektorie bewegt, und
(e) die Schritte (b) und (c) mit den jeweils gleichen Sensoranordnungen durchgeführt werden, wie bei dem Objekt auf der ersten Trajektorie.

Als besonders vorteilhaft hat sich das Verfahren herausgestellt, wenn ein Sensor ein Mikroskopkopf und ein Sensor ein Scankopf ist und korrespondierende Arbeitsschritte auf den Trajektorien zeitversetzt durchgeführt werden. Ein Ablauf kann dann wie folgt erfolgen:
(a') Beladen des Inspektionssystems mit einem ersten Objekt zur Bewegung auf der ersten Trajektorie;
(b') Ausrichten des ersten Objekts unter Verwendung der ersten Sensoranordnung in Form eines Mikroskopkopfes und teilweise zeitgleiches Beladen des Inspektionssystems mit einem zweiten Objekt zur Bewegung auf der zweiten Trajektorie;
(c') Bewegen des ersten Objekts zu der zweiten Sensoranordnung in Form eines Scankopfes;
(d') Aufnehmen eines Bildes des ersten Objektes oder zumindest eines Teils davon mit dem Scankopf und wenigstens teilweise zeitgleiches Ausrichten des zweiten Objekts unter Verwendung des Mikroskopkopfes;
(e') Zurückbewegen des ersten Objektes zum Mikroskopkopf und wenigstens teilweise zeitgleiches Bewegen des zweiten Objektes zum Scankopf;
(f') Aufnehmen eines Bildes des zweiten Objektes mit dem Scankopf;
(g') Entladen des ersten Objektes;
(h') Zurückbewegen des zweiten Objekts zum Mikroskopkopf und Entladen des Objektes und wenigstens teilweise zeitgleiches Wiederholen der Schritte (a') bis (g') sofern weitere Objekte für die Inspektion vorgesehen sind.

Optional können ein oder mehrere detailierte(s) Bild(er) des ersten Objektes zeitgleich zu Schritt (f') aufgenommen werden. Weiterhin kann optional ein detailiertes Bild des zweiten Objektes aufgenommen werden, während ein Objekt zur Bewegung auf der ersten Trajektorie beladen wird. Ein mit einem Scankopf aufgenommenes Gesamtbild oder Teilbild eines Wafers kann sich dabei aus vielen Einzelbildern zusammensetzen. Mit dem Mikroskopkopf werden ausgewählte Punkte angefahren und Einzelbilder aufgenommen.

Die vorliegende Erfindung eignet sich besonders gut für die Inspektion von Wafern in der Halbleiterindustrie. Sie ist jedoch nicht darauf beschränkt. So kann auch eine Inspektion von Teilen, Bruchstücken und anderen flachen Objekten, wie z.B. Solarzellen, Leiterplatten, Displays, gedruckte Strukturen, mit der Erfindung durchgeführt werden.

Die Erfindung ist auch nicht auf ein bestimmtes Detektionsverfahren beschränkt. So kann sowohl eine Hellfeld- als auch eine Dunkelfelddetektion implementiert werden. Nach Möglichkeit kann auch eine Mischbeleuchtung die Vorteile beider Verfahren einer Aufnahme kombinieren. Weiterhin können auch andere, bekannte Aufnahmeverfahren wie z.B. Interferenzkontrastaufnahmen (DIC), Aufnahmen unter Nutzung der Polarisation des Lichtes oder konfokale Aufnahmen eingesetzt werden. Ebenso kann eine Vorder- und/oder Rückseiteninspektion an jedem der Objekte auf beiden Trajektorien durchgeführt werden.

Für die Nutzung der Erfindung ist es unerheblich, ob die Einzelaufnahmen oder Messungen der Sensoranordnungen während einer kontinuierlichen Bewegung auf den Trajektorien erfolgt oder für jede Aufnahme oder Messung die Bewegung angehalten wird. Insbesondere kann eine Kameraanordnung als Scankopf sowohl für jede Bildaufnahme an einem Koordinatenpaar anhalten oder die Aufnahme während kontinuierlicher Bewegung durch ein Blitzlicht oder einen entsprechend schnellen Belichtungsverschluss ausgeführt werden.

Es versteht sich, dass Bilder und Messwerte mit den Sensoranordnungen sowohl für die gesamte Oberfläche, als auch für Teilbereiche davon aufgenommen werden können ohne dass vom Erfindungsgedanken abgewichen wird. Auch ist die Anzahl der Bilder oder Messwerte beliebig.

Ausgestaltungen der Erfindung sind Gegenstand der Unteransprüche. Ein Ausführungsbeispiel ist nachstehend unter Bezugnahme auf die beigefügten Zeichnungen näher erläutert.

### Kurze Beschreibung der Zeichnungen

- Fig.1: ist eine Draufsicht auf ein Inspektionssystem für Wafer.

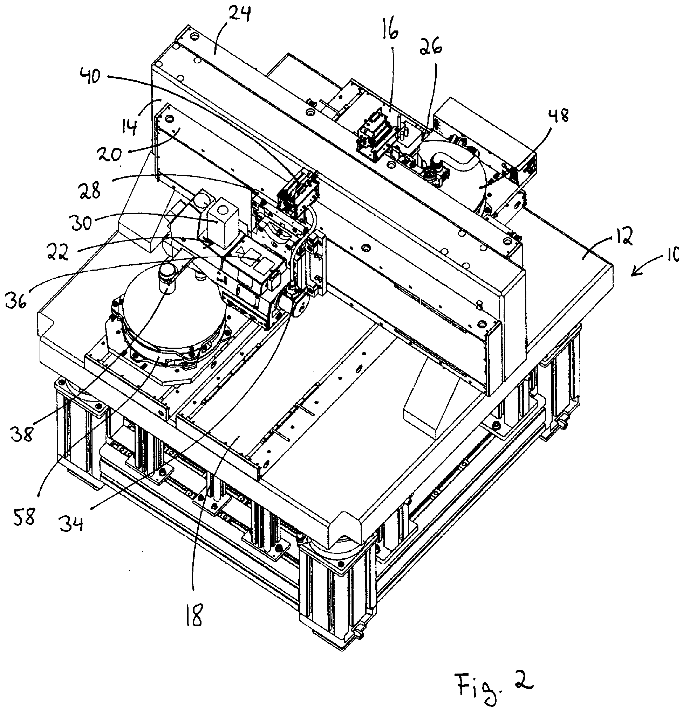

- Fig.2: zeigt das Inspektionssystem aus Figur 1 in perspektivischer Darstellung.
- Fig.3: zeigt das Inspektionssystem aus Figur 1 und 2 in einer anderen Inspektionsphase.
- Fig.4: zeigt das Inspektionssystem aus den Figuren 1 bis 3 in einer weiteren Inspektionsphase.
- Fig.5: zeigt das Inspektionssystem aus Fig.4 aus einer anderen Perspektive von vorne.
- Fig.6: zeigt das Inspektionssystem aus Figur 5 aus einer anderen Perspektive von hinten.
- Fig.7: entspricht der Darstellung aus Figur 1 mit aufliegendem Wafer.

### Beschreibung des Ausführungsbeispiels

In den Figuren ist ein allgemein mit 10 bezeichnetes Inspektionssystem für Wafer 11, 13 dargestellt. Das Inspektionssystem 10 umfasst eine flächenhafte, plane Granit-Basis 12. Auf der Granit-Basis 12 ist ein Granit-Portal 14 befestigt. Das Granit-Portal 14 erstreckt sich über die gesamte Länge der Granit-Basis 12. Das Granit-Portal 14 definiert eine Y-Achse. Unterhalb des Granit-Portals 14 sind zwei Führungsschienensysteme 16 und 18 auf der Granit-Basis 12 befestigt. Die Führungsschienensysteme 16 und 18 verlaufen parallel in Richtung einer X-Achse. Die Projektion der durch das Granit-Portal 14 definierten Y-Achse bildet einen rechten Winkel mit der X-Achse.

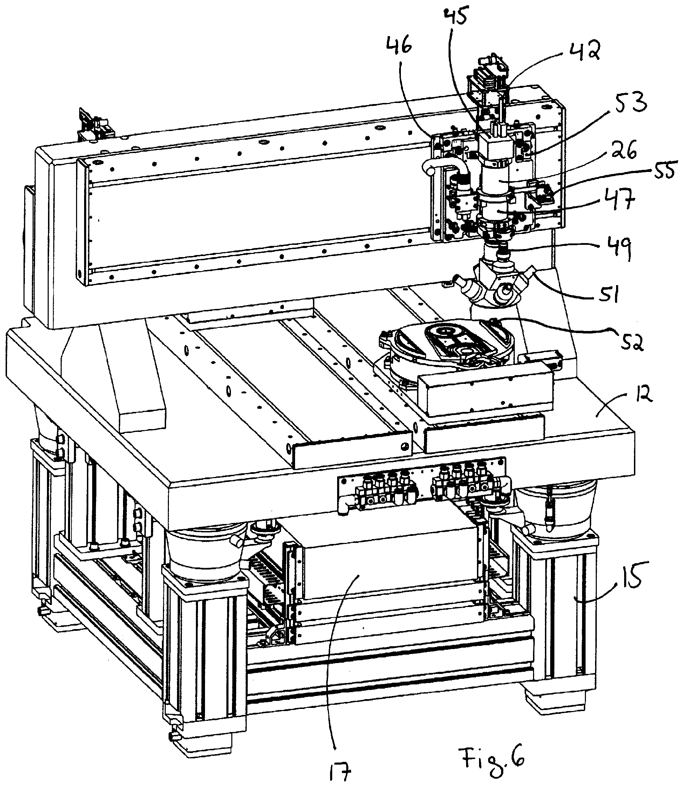

Nicht oder nur teilweise dargestellt sind die für derartige Systeme üblichen Peripheriekomponenten wie Handling System zum Be- und Entladen, Gestell 15 (Fig.6) und Gehäuse, Filter-Luftzufiihrungseinheit und Luftführungseinrichtungen sowie die notwendigen elektronischen Controller 17 und Versorgungssysteme die z.T. zur Platzersparung unter- und oberhalb des Granitportalsystems 12, 14 integriert sind.

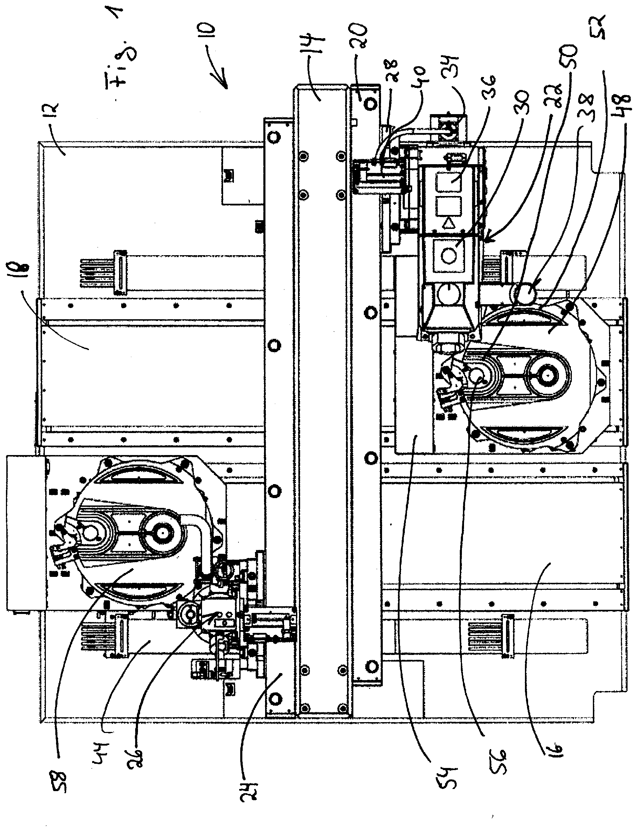

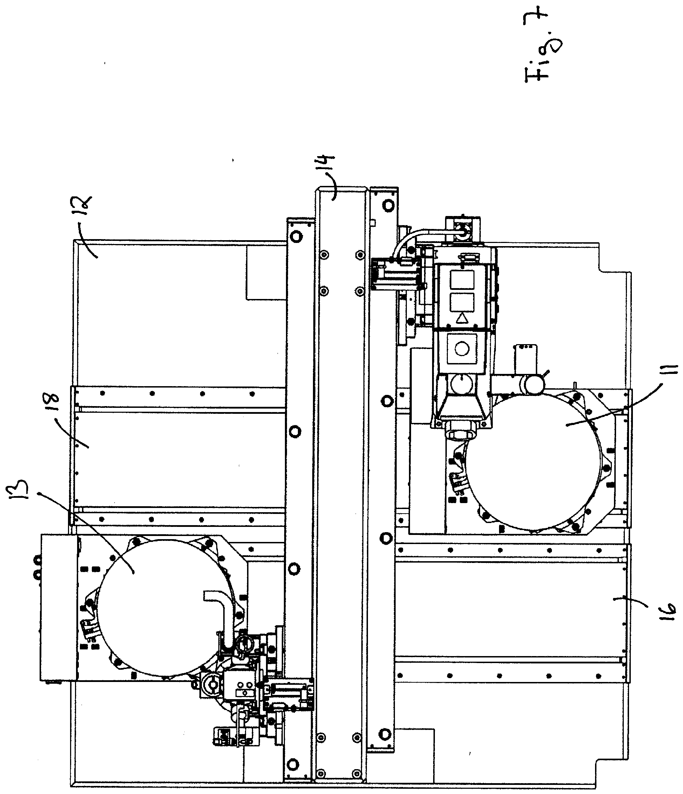

An der Vorderseite, in Figur 1 und 7 unten dargestellt, des Granit-Portals 14 ist eine in Y-Richtung verlaufende Führungsschiene 20 befestigt. An der Führungsschiene 20 ist ein allgemein mit 22 bezeichneter Mikroskop-Kopf beweglich geführt.

An der Rückseite, in Figur 1 und 7 oben dargestellt, des Granit-Portals 14 ist eine weitere, in Y-Richtung verlaufende Führungsschiene 24 befestigt. An der Führungsschiene 24 ist ein allgemein mit 26 bezeichneter Scan-Kopf beweglich geführt.

Beide Führungssysteme 20 und 24 sind so ausgestaltet, dass die Reinheitsanforderungen der jeweiligen Nutzer des Systems erfüllt werden. Dies umfasst die Verwendung von Führungs- und Antriebseinrichtungen, welche wenig Partikel erzeugen, den Einsatz geeigneter Schmiermittel mit geringer Partikelabgabe, geeignete Abdeckungen der beweglichen Teile, geeignete Anordnungen der unvermeidlichen Öffnungen sowie Möglichkeiten zur Absaugung der Innenräume des Führungssystems verbunden mit möglichst klein gehaltenen Öffnungen um die erzeugten Partikel abzuführen und somit an einem Austritt in Richtung der Probe (des Wafers) zu hindern. Dieselben Überlegungen treffen für die notwendigen Energie- und Signalverbindungen zu den beweglichen Komponenten zu, wie sie weiter unten benannt werden. Die für das Verfahren notwendige Positionierungspräzision wird durch den Einsatz entsprechend ausgelegter Führungskörper sowie durch die verwendeten Positionsmeßsysteme gewährleistet.

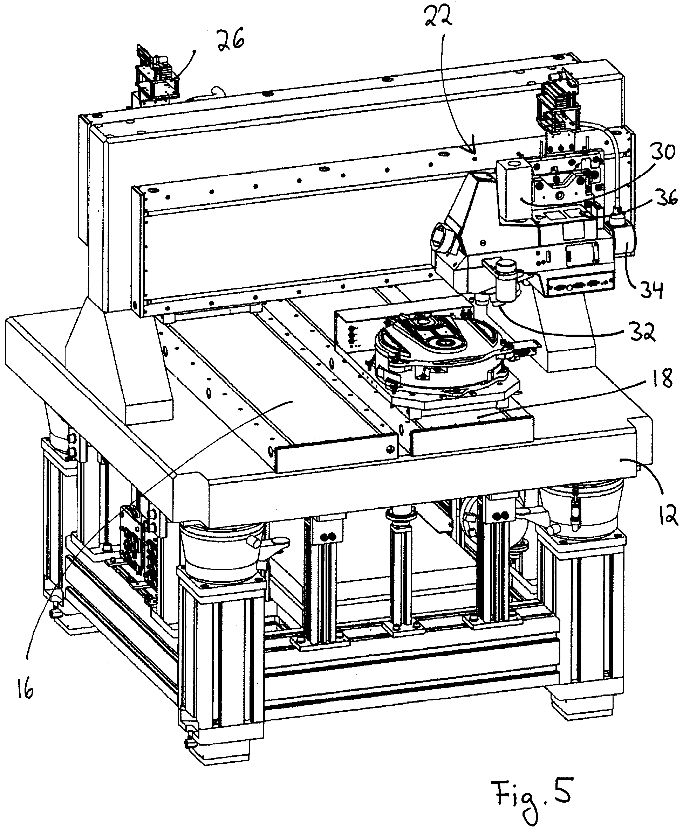

Der Mikroskopkopf 22 umfasst einen an der Führungsschiene 20 geführten Schlitten 28. Der Schlitten umfasst Einstellmöglichkeiten für die Justage des Mikroskops gegenüber dem beobachteten Bereich. Die Justageelemente sind zur Erleichterung von Wartungsarbeiten so ausgebildet, dass der Kopf durch das Lösen weniger Fixierelemente demontiert werden kann, ohne die Justage zu zerstören, so dass bei der Widermontage des Kopfes i.d.R. nicht erneut justiert werden muss. Das Mikroskop enthält alle üblicherweise für ein Auflichtmikroskop notwendigen Komponenten, insbesondere einen Beleuchtungsstrahlengang mit Feld- und Aperturblende, Filter, Vorrichtungen zur Homogenisierung der Ausleuchtung und Einspiegelung des Lichtes in das Objektiv sowie einen Bildstrahlengang mit der notwendigen Abbildungsoptik um das Objekt (die Waferoberfläche) auf die Sensorebene der Kamera abzubilden. Dadurch ist es möglich, die Köhlerschen Abbildungsbedingungen in vollem Umfang zu erfüllen. Auf dem Mikroskop ist eine Kamera 30 befestigt. Im Ausführungsbeispiel kann sowohl eine Flächenkamera als auch eine Zeilenkamera eingesetzt werden. Mit Mikroskop-Objektiven 32 (dargestellt in Fig. 5) wird ein Bild eines beobachteten Bereichs in die Abbildungsebene der Kamera 30 abgebildet. Die Beleuchtung des beobachteten Bereichs erfolgt mittels Licht, welches über einen Lichtleiter eingekoppelt wird. Hierzu ist die Schnittstelle 34 vorgesehen, die mittels eines Kollimators das Licht aus dem Lichtleiter auf die Strahlbedingungen im Mikroskop anpasst. Es sind ferner ein Laser-Autofokus 36 und eine Analysator-Einheit 38 für DIC-Kontrast in dem Mikroskopkopf 22 vorgesehen. Der Laser-Autofokus 36 spiegelt einen Laserstrahl in die Mikroskopoptik ein und wertet den rückreflektierten Strahl aus. Damit ist es möglich, in Echtzeit zu prüfen, ob die beobachtete Objektfläche in der Fokusebene des Mikroskops liegt. Über eine Rückkopplung mit dem Hubsystem des Tisches (weiter unten dargestellt) kann so jederzeit eine Tischnachführung erfolgen und die Bedingung für eine scharfe Abbildung eingehalten werden. Die Analysator-Einheit 38 dient zusammen mit polarisierenden Elementen im Mikroskop für die mögliche Nutzung des differentiellen Interferenzkontrastes zur Abbildung. Das Mikroskop ist prinzipiell mit weiteren Komponenten erweiterbar, um andere Abbildungs- und Messverfahren zu nutzen. Energieversorgung und Signalübertragung erfolgen über ein flexibles Bandkabel, welches an einer Endklemme 40 angeschlossen wird. Das Bandkabel erfüllt die notwendigen Reinheitsbedingungen und wird reibungsfrei geführt. Die eingesetzten Lichtleiter werden separat geführt wobei für eine geringe Partikelemission auf Berührungsfreiheit mit anderen Teilen und Reibungsfreiheit sowie auf möglichst große Biegeradien geachtet wird.

In der Ansicht in Figur 6 ist der Scan-Kopf 26 zu erkennen. Der Scan-Kopf 26 ist ebenfalls über ein flexibles Bandkabel 44 an die - nicht dargestellte - Elektronik angeschlossen. Hierfür ist eine Endklemme 42 vorgesehen. Der Scan-Kopf 26 ist auf einem Führungsschlitten 46 befestigt, mit welchem er in Y-Richtung an dem Granit-Portal 14 bewegbar ist. Der Scan-Kopf 26 besteht aus den Hauptkomponenten Kamera 45, Objektiv 47, Lichteinkopplung für Hellfeldbeleuchtung 49, Lichteinkopplung für Dunkelfeldbeleuchtung 51 sowie Justage- und Fixierelementen 53. Die Lichteinkopplungen erfolgen jeweils über Lichtleiter, um die bewegte Gesamtmasse gering zu halten. Das Dunkelfeldlicht wird dazu in mehrere Lichtleiter-Armen aufgeteilt und die Beobachtungsfläche wird von entsprechend vielen Lichtflecken ausgeleuchtet. Die Einstrahlung des Lichtes erfolgt unter einem Winkel von mehreren Seiten um die Homogenität der Beleuchtung zu gewährleisten.

Als Justageelement ist neben der Vorrichtung zum senkrechten Ausrichten der optischen Achse zur Waferoberfläche insbesondere eine sehr feine Einstellmöglichkeit 55 für die Verdrehung der Kamera gegenüber der Bewegungsrichtung des Scankopfes während des Scannens vorgesehen, um im Zusammenspiel mit der Winkelausrichtung des Wafers sicherzustellen, dass Kamerabild (oder Zeile) und Hauptstrukturachsen des Wafers parallel zueinander laufen, da durch eine gegenseitige Verdrehung Artefakte in der Bildverarbeitung entstehen könnten.

In dem Führungsschienensystem 18 ist ein Wafer-Tisch 48 beweglich geführt. Die zu untersuchenden Wafer werden mittels eines handelsüblichen Handling-Systems (nicht dargestellt) auf dem Wafer-Tisch 48 abgelegt. Der Wafer-Tisch 48 weist eine Auflage mit Vakuum-Ansaugkanälen zur Waferauflage und Fixierung bei der Vorderseiteninspektion auf. Der Wafer-Tisch 48 ist weiterhin für die Rückseiteninspektion mit einer Klemmvorrichtung 50 und mehreren Auflagepunkten 52 welche nur den Waferrand berühren versehen. Diese Auflagepunkte sind versetzt zur Auflage für die Vorderseiteninspektion angeordnet, so dass sich beide Auflagevorrichtungen bzw. der jeweils aufgelegte Wafer nicht gegenseitig behindern. Der Wafer wird auf ihnen durch die Klemmvorrichtung 50 gehalten. Der Wafer-Tisch 48 verfügt über motorische Hub- und Drehmöglichkeiten zum Ausrichten des Wafers. Mittels der Drehvorrichtung kann die Waferlage so eingestellt werden, dass während des Scannens des Wafers der Scankopf exakt parallel zu Hauptstrukturachsen auf dem Wafer geführt wird. Mit der Hubvorrichtung lassen sich unterschiedliche Wafer in die Fokusebene der Optik von Mikroskop bzw. Scankopf bringen, Außerdem können damit insbesondere durchhängende Wafer, z.B. bei der Rückseiteninspektion in der Höhe nachgeführt werden, so dass die Lage des Wafers in der Fokushöhe im aktuellen Aufnahmepunkt während der gesamten Bearbeitung gewährleistet ist. Ein Tisch-Controller 54 steuert und koordiniert die Tischbewegung in Richtung des Führungsschienensystems 18 (X-Richtung). Es ist ferner ein Wafer-Anwesenheitssensor 56 vorgesehen der zusammen mit der Vakuumerkennung bzw. der Rückmeldung der Stellung der Klemmvorrichtung 50 eine hohe Sicherheit für die Erkennung der Anwesenheit und korrekten Lagefixierung der Wafer gewährleistet.

In dem Führungsschienensystem 16 ist ein Wafer-Tisch 58 beweglich geführt. Der Wafer-Tisch 58 ist identisch aufgebaut wie der Wafer-Tisch 48 und braucht daher hier nicht weiter beschrieben werden.

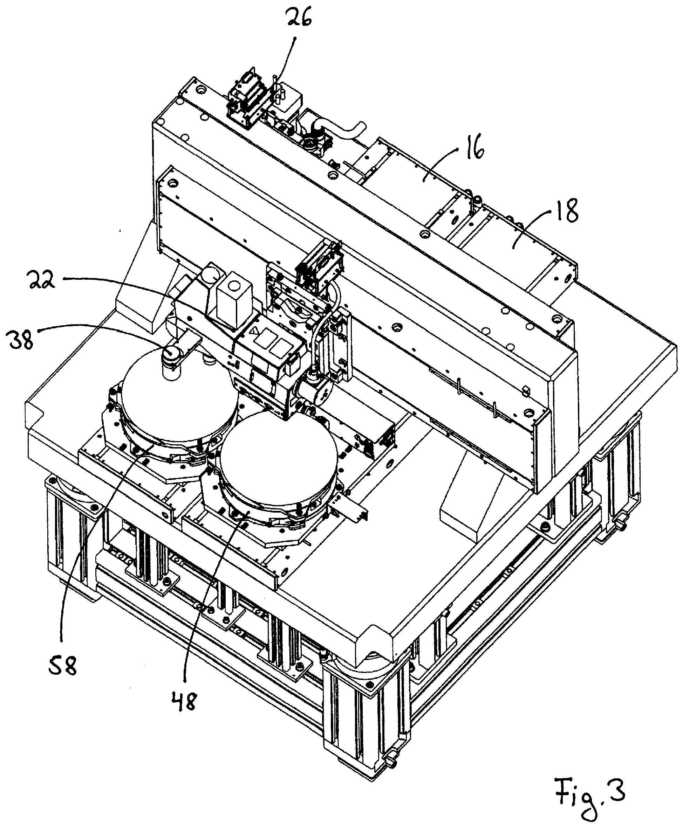

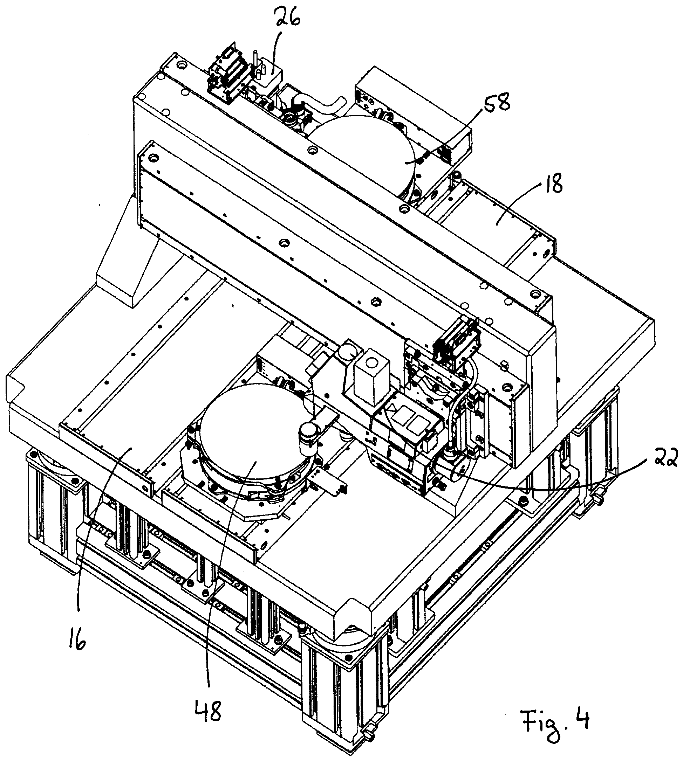

Die beschriebene Anordnung arbeitet wie folgt:
Die Wafer-Tische 48 und 58 befinden sich anfänglich in einer Endstellung, wie dies in Figur 3 dargestellt ist. Das (nicht-dargestellte) Handling System legt einen zu untersuchenden Wafer auf den Wafer-Tisch 58. Der Wafer wird dann mit Hilfe des Mikroskopkopfs 22 ausgerichtet (Registrierung des Wafers) und in der Höhe justiert. Zu diesem Zweck wird der Mikroskopkopf 22 in Y-Richtung bewegt, bis er oberhalb des Führungsschienensystems 16 positioniert ist. Nach der Justage wird der Wafer-Tisch 58 mit dem Wafer in dem Führungsschienensystem 16 in die in Figur 4 dargestellte Position gefahren. Der Scankopf 26 wird in Y-Richtung bewegt, bis er oberhalb des Führungsschienensystems 16 positioniert ist. In dieser Position wird der Wafer auf dem Wafer-Tisch 58 mit dem Scankopf 26 gescannt. Dabei werden ein oder mehrere Bilder des gesamten Wafers oder größerer Teilbereiche des Wafers aufgenommen. Zeitnah oder gleichzeitig wird der Mikroskopkopf 22 in Y-Richtung bewegt, bis er oberhalb des Führungsschienensystems 18 positioniert ist, um den dort vom Handling System bereits aufgelegten Wafer zu bearbeiten. Dies ist in Figur 4 dargestellt. Der Wafer auf dem Wafer-Tisch 48 wird ebenfalls mit Hilfe des Mikroskopkopfs 22 ausgerichtet und in der Höhe justiert. Nach beendetem Scannen wird der erste Wafer auf dem Wafer-Tisch 58 entladen. Dazu wird der Wafer-Tisch 58 in X-Richtung zurück in die Ausgangsposition gefahren. Alternativ können vor dem Entladen des Wafers von Wafer-Tisch 58 Detailbilder mittels des Mikroskopkopfes 22 aufgenommen werden. Zeitnah oder gleichzeitig wird der Wafer-Tisch 48 in X-Richtung bewegt, bis er unterhalb des Scankopfes 26 positioniert ist. Der Scankopf 26 wird gleichzeitig in Y-Richtung bewegt, bis er oberhalb des Führungsschienensystems 18 positioniert ist. Diese Position entspricht der Situation in Figur 4, wobei jedoch die Lage der Wafer-Tische 48 und 58 und des Scankopfes 26 mit dem Mikroskop-Kopf 22 vertauscht ist. In dieser Position wird der Wafer auf dem Wafer-Tisch 48 gescannt und ein dritter Wafer auf den Wafer-Tisch 58 aufgelegt. Die oben aufgeführten Schritte werden wiederholt, bis alle zu untersuchenden Wafer abgearbeitet sind.

Im vorliegenden Ausführungsbeispiel wurde der erste Wafer auf den Wafer-Tisch 58 aufgelegt. Es versteht sich, dass auch mit dem identischen Wafer-Tisch 48 begonnen werden kann.

In weiteren Ausführungsbeispielen wird ein Mikroskopkopf an die Stelle des Scankopfes 26 gesetzt. Dies ist immer dann sinnvoll, wenn lediglich kleine Bereiche der Wafer untersucht werden sollen.

Die beschriebene Abfolge der Arbeitsschritte modifiziert sich in den verschiedenen Ausgestaltungen z.B. bei der Verwendung von zwei Mikroskopköpfen oder zwei Scanköpfen auf einer gemeinsamen Achse entsprechend.

## Patentansprüche

1. Inspektionssystem für flache Objekte, insbesondere Wafer und Dies, enthaltend
(a) ein Handling-System zum Beladen des Inspektionssystems mit Objekten;
(b) eine Sensoranordnung zur Aufnahme von Bildern oder Messwerten der Objektoberfläche oder Teilen der Objektoberfläche;
(c) eine Antriebsanordnung zur Erzeugung einer Relativbewegung zwischen den Objekten und der Sensoranordnung, bei welcher eine Bewegung von Objekten relativ zu der Sensoranordnung entlang einer ersten Trajektorie erfolgt; und
(d) wenigstens eine weitere Sensoranordnung zur Aufnahme von Bildern oder Messwerten der Objektoberfläche oder Teilen der Objektoberfläche; wobei
(e) mit der Antriebsanordnung eine weitere Relativbewegung erzeugbar ist, bei welcher eine Bewegung von anderen Objekten relativ zu jeder der Sensoranordnungen auf wenigstens einer zweiten Trajektorie erzeugbar ist, so dass Bilder oder Messwerte der Objektoberfläche oder von Teilen der Objektoberfläche von wenigstens zwei Objekten gleichzeitig mit den Sensoranordnungen aufnehmbar sind, **dadurch gekennzeichnet, dass**
(f) jede der Sensoranordnungen in den Bereich aller Trajektorien der Objekte bewegbar ist.

2. Inspektionssystem nach Anspruch 1, **dadurch gekennzeichnet, dass** Objekte auf zwei geraden parallelen Trajektorien bewegbar sind.

3. Inspektionssystem nach Anspruch 1 oder 2, **dadurch gekennzeichnet, dass** die Sensoranordnungen auf geraden parallelen Trajektorien bewegbar sind.

4. Inspektionssystem nach Anspruch 2 und 3, **dadurch gekennzeichnet, dass** die Trajektorien der Sensoranordnungen windschief mit rechtwinkliger Projektion zu den Trajektorien der Objekte verlaufen.

5. Inspektionssystem nach einem der vorgehenden Ansprüche, **dadurch gekennzeichnet, dass** die Sensoranordnungen wenigstens einen Mikroskopkopf umfassen.

6. Inspektionssystem nach einem der vorgehenden Ansprüche, **dadurch gekennzeichnet, dass** die Sensoranordnungen wenigstens einen Scankopf umfassen.

7. Inspektionssystem nach einem der vorgehenden Ansprüche, **dadurch gekennzeichnet, dass** die Trajektorien von raumfesten Führungen gebildet sind, welche jeweils einen darin geführten, verschiebbaren Hub-Drehtisch zur Aufnahme und Ausrichtung der Objekte aufweisen.

8. Inspektionssystem nach einem der vorgehenden Ansprüche, **dadurch gekennzeichnet, dass** die Sensoranordnungen jeweils auf einem sich oberhalb der Trajektorien der Objekte befindlichen Portalbalken verschiebbar geführt sind.

9. Inspektionssystem nach einem der vorgehenden Ansprüche, **dadurch gekennzeichnet, dass** wenigstens eine der Sensoranordnungen von einer Schwarz-Weiß-Kamera oder einer Farbbildkamera gebildet ist.

10. Inspektionssystem nach einem der vorgehenden Ansprüche, **dadurch gekennzeichnet, dass** wenigstens eine der Sensoranordnungen ein Flächensensor mit einer zweidimensionalen Anordnung von Detektorelementen ist.

11. Inspektionssystem nach einem der vorgehenden Ansprüche, **dadurch gekennzeichnet, dass** eine der Sensoranordnungen tragenden Achsen mit zwei unabhängig von einander steuerbaren Sensoranordnungen bestückt ist.

12. Verfahren zur Durchführung einer Inspektion einer Vielzahl von flachen Objekten, insbesondere Wafern und Dies, mit einem Inspektionssystem nach einem der vorgehenden Ansprüche, mit den Schritten:
(a) Beladen des Inspektionssystems mit einem Objekt zur Bewegung auf einer ersten Trajektorie;
(b) Aufnehmen wenigstens eines Bildes oder eines Messwertes des Objekts oder eines Teils des Objekts mit einer ersten Sensoranordnung; und
(c) Aufnehmen eines weiteren Bildes oder eines weiteren Messwertes des Objekts oder eines Teils des Objekts mit einer zweiten Sensoranordnung;
**dadurch gekennzeichnet, dass**
(d) während der Durchführung eines der Schritte (a) bis (c) ein anderer der Schritte (a) bis (c) für ein weiteres Objekt durchgeführt wird, welches sich auf einer zweiten Trajektorie bewegt, und
(e) die Schritte (b) und (c) mit den jeweils gleichen Sensoranordnungen durchgeführt werden, wie bei dem Objekt auf der ersten Trajektorie.

13. Verfahren nach Anspruch 12, **gekennzeichnet durch** die Schritte:
(a') Beladen des Inspektionssystems mit einem ersten Objekt zur Bewegung auf der ersten Trajektorie;
(b') Ausrichten des ersten Objekts unter Verwendung der ersten Sensoranordnung in Form eines Mikroskopkopfes und teilweise zeitgleiches Beladen des Inspektionssystems mit einem zweiten Objekt zur Bewegung auf der zweiten Trajektorie;
(c') Bewegen des ersten Objekts zu der zweiten Sensoranordnung in Form eines Scankopfes;
(d') Aufnehmen eines Bildes oder Messwertes des ersten Objektes oder zumindest eines Teils davon mit dem Scankopf und wenigstens teilweise zeitgleiches Ausrichten des zweiten Objekts unter Verwendung des Mikroskopkopfes;
(e') Zurückbewegen des ersten Objektes zum Mikroskopkopf und wenigstens teilweise zeitgleiches Bewegen des zweiten Objektes zum Scankopf;
(f') Aufnehmen eines Bildes des zweiten Objektes mit dem Scankopf;
(g') Entladen des ersten Objektes;
(h') Zurückbewegen des zweiten Objekts zum Mikroskopkopf und Entladen des Objektes und wenigstens teilweise zeitgleiches Wiederholen der Schritte (a') bis (g') sofern weitere Objekte für die Inspektion vorgesehen sind.

14. Verfahren nach Anspruch 13 **dadurch gekennzeichnet, dass** ein Bild des ersten Objektes zeitgleich zu Schritt (f') aufgenommen wird.

15. Verfahren nach Anspruch 13 oder 14, **dadurch gekennzeichnet, dass** ein Bild des zweiten Objektes aufgenommen wird, während ein Objekt zur Bewegung auf der ersten Trajektorie beladen wird.

## Claims

1. Inspection system for flat objects, especially wafers and dies, comprising:
(a) a handling system for loading objects into the inspection system;
(b) a sensor assembly for receiving images or measuring values of the object surface or parts of the object surface;
(c) a driving assembly for generating a relative movement between the objects and the sensor assembly, where a movement is effected between objects relative to the sensor assembly along a first trajectory; and
(d) at least one further sensor assembly is provided for receiving images or measuring values of the object surface or parts of the object surface wherein;
(e) the driving assembly is adapted to generate a further relative movement, where a movement of different objects relative to the sensor assembly can be generated on at least a second trajectory in order to allow at least two objects to be treated simultaneously with the sensor assemblies
**characterized in that**
(f) each of the sensor assemblies is configured to be moved in the range of all trajectories of the objects.

2. Inspection system according to claim 1, **characterized in that** the objects are moved on two straight, parallel trajectories.

3. Inspection system according to claim 1 or 2, **characterized in that** the sensor assemblies are moved on two straight, parallel trajectories.

4. Inspection system according to claim 2 or 3, **characterized in that** the trajectories of the sensors extend in such way that the projection is orthogonal to the trajectories of the objects.

5. Inspection system according to any of the preceding claims, **characterized in that** the sensor assemblies comprise at least one microscope head.

6. Inspection system according to any of the preceding claims, **characterized in that** the sensor assemblies comprise at least one scanning had.

7. Inspection system according to any of the preceding claims, **characterized in that** the trajectories are stationary guidings which are each provided with a lifting and rotating table which is moveably guided therein for receiving and adjusting the objects.

8. Inspection system according to any of the preceding claims, **characterized in that** the sensor assemblies are each moveably guided on a portal beam located above the trajectories of the objects.

9. Inspection system according to any of the preceding claims, **characterized in that** at least one of the sensor assemblies is a black-and-white camera or a colour camera.

10. Inspection system according to any of the preceding claims, **characterized in that** at least one of the sensor assemblies is an array sensor with a two-dimensional array of detector elements.

11. Inspection system according to any of the preceding claims, **characterized in that** one of the axes carrying a sensor assembly is equipped with two independently controllable sensor assemblies.

12. Method for carrying out an inspection of a plurality of flat objects, especially wafers and dies with an inspection system according to any of the preceding claims, with the steps of
(a) loading an object into the inspection system for movement on a first trajectory;
(b) taking at least one image or measuring value of the object or a portion of the object with a first sensor assembly; and
(c) taking a further image or a further measuring value of the object or a portion of the object with a second sensor assembly;
**characterized in that**
(d) during the carrying-out of steps (a) to (c) another step of (a) to (c) is carried out on another object moving on a second trajectory, and
(e) steps (b) and (c) are carried out with the same sensor assemblies as with the object on the first trajectory.

13. Method according to claim 12, **characterized by** the steps of
(a') loading a first object into the inspection system for movement on a first trajectory;
(b') adjusting the first object using the first sensor assembly in the form of a micro head and partially simultaneous loading of a second object into the inspection system for movement on a second trajectory;
(c') moving the first object to the second sensor assembly in the form of a scanning head;
(d') taking an image of the first object or at least a portion of the object with the scanning head and at least partially simultaneous adjusting the second object using the micro-head;
(e') returning the first object to the micro head and at least partially simultaneous moving the second object to the scanning head;
(f') taking an image of the second object with the scanning head;
(g') unloading the first object;
(h') returning the second object to the micro-head and discharging the object and at least partially simultaneous repeating steps (a') to (g') while further objects are provided for inspection.

14. Method according to claim 13, **characterized in that** a detailed image of the first object is taken simultaneous to step (f').

15. Method according to claim 13 or 14, **characterized in that** a detailed image of the second object is taken while an object is loaded for movement on the first trajectory.

## Revendications

1. Système d'inspection pour objets plats, notamment des galettes ou des dies de semi-conducteur, comprenant
(a) un système de manutention destiné à charger le système d'inspection avec des objets ;
(b) une disposition de capteurs destinée à générer des prises de vue ou des valeurs de mesure de la surface d'objet ou de parties de la surface d'objet ;
(c) une disposition d'entraînement destinée à produire un déplacement relatif entre les objets et la disposition de capteurs pour laquel un déplacement d'objets est effectué par rapport à la disposition de capteurs le long d'une première trajectoire ; et
(d) au moins une disposition de capteurs supplémentaire destinée à générer des prises de vue ou des valeurs de mesure de la surface d'objet ou de parties de la surface d'objets ;
(e) un déplacement relatif supplémentaire pouvant être produit à l'aide de la disposition d'entraînement pour lequel un déplacement d'autres objets par rapport à chacune des dispositions de capteurs peut être produit sur au moins une seconde trajectoire de sorte que des prises de vue ou des valeurs de mesure de la surface d'objet ou de parties de la surface d'objet d'au moins deux objets peuvent être générées simultanément par les dispositions de capteurs, **caractérisé en ce que**
(f) chacune des dispositions de capteurs peut se déplacer dans la zone de toutes les trajectoires des objets.

2. Système d'inspection selon la revendication 1, **caractérisé en ce que** des objets peuvent se déplacer sur deux trajectoires droites parallèles.

3. Système d'inspection selon la revendication 1 ou 2, **caractérisé en ce que** les dispositions de capteurs peuvent se déplacer sur des trajectoires droites parallèles.

4. Système d'inspection selon la revendication 2 et 3, **caractérisé en ce que** les trajectoires des dispositions de capteurs s'étendent de manière inclinée dans un angle droit de projection par rapport aux trajectoires des objets.

5. Système d'inspection selon l'une quelconque des revendications précédentes, **caractérisé en ce que** les dispositions de capteurs comprennent au moins une tête de microscope.

6. Système d'inspection selon l'une quelconque des revendications précédentes, **caractérisé en ce que** les dispositions de capteurs comprennent au moins une tête de balayage.

7. Système d'inspection selon l'une quelconque des revendications précédentes, **caractérisé en ce que** les trajectoires sont formées de guidages fixes dans l'espace qui présentent chacune un plateau tournant élévateur guidé à l'intérieur et pouvant se déplacer pour loger et orienter les objets.

8. Système d'inspection selon l'une quelconque des revendications précédentes, **caractérisé en ce que** les dispositions de capteurs sont guidées chacune de manière à pouvoir se déplacer sur une poutre de portique se trouvant au-dessus des trajectoires des objets.

9. Système d'inspection selon l'une quelconque des revendications précédentes, **caractérisé en ce qu'**au moins l'une des dispositions de capteurs est formée d'une caméra noir et blanc ou d'une caméra couleur.

10. Système d'inspection selon l'une quelconque des revendications précédentes, **caractérisé en ce qu'**au moins l'une des dispositions de capteurs est un capteur matriciel muni d'une disposition bidimensionnelle d'éléments de détecteur.

11. Système d'inspection selon l'une quelconque des revendications précédentes, **caractérisé en ce que** l'un des axes portant des dispositions de capteurs est équipé de deux dispositions de capteurs pouvant être commandées indépendamment l'une de l'autre.

12. Procédé pour la mise en oeuvre d'une inspection de plusieurs objets plats, notamment des galettes ou des dies de semi-conducteur, à l'aide d'un système d'inspection, selon l'une quelconque des revendications précédentes, comprenant les étapes de :
(a) chargement du système d'inspection avec un objet destiné à se déplacer sur une première trajectoire ;
(b) génération d'au moins une prise de vue ou d'une valeur de mesure de l'objet ou d'une partie de l'objet à l'aide d'une première disposition de capteurs ; et
(c) génération d'une prise de vue supplémentaire ou d'une valeur de mesure supplémentaire de l'objet ou d'une partie de l'objet à l'aide d'une seconde disposition de capteurs ;
**caractérisé en ce que**
(d) pendant la mise en oeuvre de l'une des étapes (a) à (c), une autre des étapes (a) à (c) est mise en oeuvre pour un objet supplémentaire qui se déplace sur une seconde trajectoire, et
(e) les étapes (b) et (c) sont mises en oeuvre avec les dispositions de capteurs qui sont les mêmes à chaque fois, comme pour l'objet sur la première trajectoire.

13. Procédé selon la revendication 12, **caractérisé par** les étapes de :
(a') chargement du système d'inspection avec un premier objet destiné à se déplacer sur la première trajectoire ;
(b') orientation du premier objet en utilisant la première disposition de capteurs sous forme de tête de microscope et chargement partiellement simultané du système d'inspection avec un second objet destiné à se déplacer sur la seconde trajectoire ;
(c') déplacement du premier objet vers la seconde disposition de capteurs sous forme de tête de balayage ;
(d') génération d'une prise de vue ou d'une valeur de mesure du premier objet ou d'au moins une partie de ce dernier à l'aide de la tête de balayage et orientation au moins partiellement simultanée du second objet en utilisant la tête de microscope ;
(e') retour du premier objet vers la tête de microscope et déplacement au moins partiellement simultané du second objet vers la tête de balayage ;
(f') génération d'une prise de vue du second objet à l'aide de la tête de balayage ;
(g') déchargement du premier objet ;
(h') retour du second objet vers la tête de microscope et déplacement de l'objet et réitération au moins partiellement simultanée des étapes (a') à (g') dans la mesure où des objets supplémentaires à inspecter sont prévus.

14. Procédé selon la revendication 13, **caractérisé en ce qu'**une prise de vue du premier objet est générée en même temps que l'étape (f').

15. Procédé selon la revendication 13 ou 14, **caractérisé en ce qu'**une prise de vue du second objet est générée pendant qu'un objet destiné à se déplacer sur la première trajectoire est chargé.
